# EUROPÄISCHE PATENTSCHRIFT

(11) **EP 2 999 971 B1**
(45) Veröffentlichungstag und Bekanntmachung des Hinweises auf die Patenterteilung: **18.09.2019**
(21) Anmeldenummer: 14727161.3
(22) Anmeldetag: 21.05.2014
(51) Int. Cl.: G01R 31/12, G01R 31/14, G01R 31/16, G01R 31/00, G01R 31/02, G01R 1/44, G01R 15/14

(54) **HOCHLEISTUNGS-HOCHSPANNUNGSPRÜFGERÄT**
HIGH-POWERED HIGH-VOLTAGE TEST DEVICE
APPAREIL D'ESSAI PAR HAUTE PUISSANCE - HAUTE TENSION

(30) Priorität: 22.05.2013 DE 102013008611
(43) Veröffentlichungstag der Anmeldung: 30.03.2016
(73) Patentinhaber: B2 Electronic GmbH, 6833 Klaus (AT)
(72) Erfinder: BLANK, Rudolf, A-6832 Sulz (AT); BALDAUF, Stefan, A-6830 Rankweil (AT)
(74) Vertreter: Grättinger Möhring von Poschinger Patentanwälte Partnerschaft mbB
(86) Internationale Anmeldenummer: PCT/EP2014/001372
(87) Internationale Veröffentlichungsnummer: WO 2014/187563

(56) Entgegenhaltungen:
- EP-A1- 0 012 721
- EP-A1- 2 590 490
- WO-A2-2009/143543
- DE-A1- 19 513 441
- DE-A1-102007 034 558

## Beschreibung

Die vorliegende Erfindung betrifft ein Hochleistungs-Hochspannungsprüfgerät umfassend Mittel zur Erzeugung einer Prüfspannung bei einer Leistung von größer als 1 kW, wobei die Prüfspannung eine Wechselspannung mit ei ner Amplitude von wenigstens 100 kV ist und wobei die Mittel zur Erzeugung der Prüfspannung wenigstens zwei Spannungsverstärkerzweige aufweisen, von denen ein ers ter Spannungsverstärkerzweig zur Erzeugung der positiven Spannungshalbwellen der Prüfspannung und ein zweiter Spannungsverstärkerzweig zur Erzeugung der negativen Spannungshalbwellen der Prüfspannung dient bzw. beiträgt. Ferner weist ein gattungsgemäßes Hochleistungs-Hochspannungsprüfgerät eine Messschaltung zu Messung der an einem Messobjekt anzulegenden Prüfspannung und des hierdurch im Messobjekt verursachten Prüf stroms auf.

Derartige Hochspannungsprüfgeräte sind aus dem Stand der Technik hinlänglich bekannt und dienen der Prüfung von Messobjekten, bei denen es sich um verschiedenste elektrische oder elektronische Bauteile oder insbesondere um Hoch- oder Mittelspannungskabel handeln kann. Dabei wird das zu prüfende Messobjekt mit einer in der Regel sinusförmigen Wechselspannung (mit hoher Amplitu de größer 100 kV) in dem genannten Leistungsbereich be aufschlagt und - unter Ermittlung und Auswertung der a dem Messobjekt anliegenden Prüfspannung und des hierdurch verursachten Prüfstroms - z.B. eine Aussage dahingehend getroffen, ob das geprüfte Messobjekt für einen vorgegebenen Zeitraum der Prüfspannung ohne Spannungsdurchschlag Stand gehalten hat. Ferner kann z.B. unter sukzessiver Erhöhung der Prüfspannung gegebenenfalls auch bestimmt werden, ab welcher Prüfspannung sicherheitsrelevante Spannungsdurchschläge stattfinden bzw. stattgefunden haben. Außerdem lässt sich, insbesondere wenn das gattungsgemäße Hochspannungsprüfgerät zur Erzeugung einer bevorzugt sinusförmigen VLF(Very-Low-Frequency)-Wechselspannung mit einer Frequenz im Bereich zwischen 0,01 Hz und 1 Hz eingerichtet ist, unter Auswertung der gegebenen Phasenverschiebung zwischen Prüfspannung und Prüfstrom auch der sogenannte Verlustfaktor (tan δ) des Messobjekts bestimmen, mit welchem im Rahmen einer zerstörungsfreien Prüfung z.B. eine Aussage zur Qualität bzw. zum Alterungszustand der Isolierung von Hoch- bzw. Mittelspannungskabeln getroffen werden kann. Die insoweit anzuwendenden Mess- und Auswertealgorithmen (und die hierfür notwendigen Mess- und Auswerteschaltungen) sind dem einschlägigen Fachmann hinlänglich bekannt.

Die Prüfspannung wird dabei im Stand der Technik, wie dies einleitend erläutert ist, häufig unter Verwendung zweier in ein gattungsgemäßes Hochspannungsprüfgeräte integrierter Spannungsverstärkerzweige erzeugt, von denen der eine die positiven Spannungshalbwellen und der andere die negativen Spannungshalbwellen der Prüfspannung erzeugt, mit welchen das Messobjekt dann auf geeignete Weise wechselweise zu beaufschlagen ist.

Insbesondere im Falle der VLF-Prüfung von Hoch- oder Mittelspannungskabeln bestehen mit zunehmender Länge des zu prüfenden Kabels besonders hohe Anforderungen an die von gattungsgemäßen Prüfgeräten aufzubringende Spannungsamplitude und elektrische Leistung, so dass ein großer Bedarf für entsprechend leistungsstarke Prüfgeräte besteht. Ferner ist im Rahmen der vorliegenden Erfindung von Bedeutung, dass Hochleistungs-Hochspannungsprüfgeräte der gattungsgemäßen Art in der Regel zu dem zu prüfenden Messobjekt transportiert werden müssen, was bei den aus dem Stand der Technik bekannten Geräten nicht immer einfach möglich ist.

Derzeit sind mobile (VLF-)Hochleistungs-Hochspannungsprüfgeräte der eingangs genannten Art mit Mitteln zur Erzeugung einer sinusförmigen VLF-Prüfspannung mit einer Amplitude von bis zu 200 kV (entsprechend ca. 141 kV Effektivspannung) bei elektrischen Ausgangsleistungen von bis zu ca. 8 kW verfügbar.

Selbstverständlich werden die Kosten von (mobilen) Hochleistungs-Hochspannungsprüfgeräten gattungsgemäßer Art maßgeblich durch die von dem betreffenden Gerät aufzubringende Ausgangsleistung bestimmt, so dass in der Praxis Hochspannungsprüfgeräte der eingangs genannten Art in der Regel in verschiedenen Leistungsklassen angeboten werden, deren Einsatzmöglichkeiten - abhängig von der mit den betreffenden Prüfgeräte erzeugbaren Spannungsamplitude und der hierbei zur Verfügung stehenden Ausgangsleistung - beschränkt sind.

Und schließlich erweist sich, insbesondere wenn bei Hochspannungsprüfgeräten eine hohe Ausgangsleistung zur Verfügung gestellt werden soll, zunehmend die erforderliche Kühlung der Hochspannungselektronik, insbesondere der darin hochspannungsseitig angeordneten Komponenten in den verschiedenen Spannungsverstärkerzweigen als problematisch. Dies gilt insbesondere dann, wenn die genannten Geräte als mobile Prüfgeräte zu dem Messobjekt transportiert werden müssen, was im Stand der Technik häufig durch Bereitstellung eines möglichst kompakten Geräteaufbaus realisiert ist.

Das Dokument DE19513441A1 offenbart ein Hochleistungs-Hochspannungsprüfgerät umfassend Mittel zur Erzeugung einer Prüfspannung, die wenigstens zwei Spannungsverstärkerzweige aufweisen, von denen ein erster Spannungsverstärkerzweig zur Erzeugung der positiven Spannungshalbwellen der Prüfspannung und ein zweiter Spannungsverstärkerzweig zur Erzeugung der negativen Spannungshalbwellen der Prüfspannung beiträgt, und eine Messschaltung zur Messung der an einem Messobjekt anzulegenden Prüfspannung und des hierdurch im Messobjekt verursachten Prüfstroms.

Das Dokument EP2590490A1 offenbart ein innerhalb eines Containers modular aufgebautes Prüfsystem mit verschiedenen elektrischen Komponenten (Umrichter, Wechselrichter) als Wärmequellen.

Das Dokument DE102007034558A1 offenbart ein Hochspannungsprüfgerät mit aktiver Luftkühlung.

Vor diesem Hintergrund ist es die Aufgabe der vorliegenden Erfindung, ein Hochleistungs-Hochspannungsprüfgerät der eingangs genannten Art dahingehend weiterzubilden, dass dieses trotz hinreichend hoher elektrischer Ausgangsleistung auf möglichst einfache Weise ausreichend gekühlt und einfach transportiert werden kann, wobei in Zusatzaspekten der Erfindung und seiner bevorzugten Weiterbildungen insbesondere auch eine Möglichkeit zur möglichst einfachen Erhöhung der mit erfindungsgemäßen Hochspannungsprüfgeräten bereitstellbaren Ausgangsleistung geschaffen wird.

Diese Aufgabe wird im Rahmen der vorliegenden Erfindung gemäß Anspruch 1 dadurch gelöst, dass bei einem gattungsgemäßen Hochleistungs-Hochspannungsprüfgerät jeder Spannungsverstärkerzweig in einer separaten Baugruppe mit integrierter aktiver Luftkühlung verbaut ist.

Dadurch, dass vorliegend die Hochspannungsquelle, also die Mittel zur Erzeugung der Prüfspannung in wenigstens zwei je einen Spannungsverstärkerzweig enthaltende separate Baugruppen aufgeteilt ist, wobei in jede Baugruppe eine separate aktive Luftkühlung integriert ist, kann man dem besonders hohen Kühlbedarf eines gattungsgemäßen Hochspannungsprüfgeräts in besonders einfacher Weise gerecht werden. Jeder Verstärkerzweig wird somit durch eine eigene Luftkühlung der betreffenden Baugruppe aktiv gekühlt.

Im Übrigen ist das erfindungsgemäße Hochspannungsprüfgerät besonders einfach transportabel, da die separaten
- jeweils einen Spannungsverstärkerzweig beinhaltenden
- Baugruppen in vorteilhafter Weise auch separat zu einem bestimmten Aufstellungsort transportiert werden können und erst dort auf geeignete Weise mit dem Prüfling bzw. untereinander bzw. mit weiteren Komponenten (z.B. einer zentralen Steuereinheit) des Hochspannungsprüfgeräts verbunden werden müssen, wobei die separaten Baugruppen besonders bevorzugt räumlich getrennt voneinander aufstellbar sind.

Vorteilhaft ist jede Baugruppe in Art eines separaten bzw. separat aufstellbaren Geräts mit eigenem Gehäuse ausgestaltet, wobei jede Baugruppe, wie dies weiter unten noch näher erläutert wird, gegebenenfalls auch ihrerseits aus (wenigstens) zwei miteinander lösbar verbundenen Elementen oder Gehäuseabschnitten bestehen kann.

Soweit vorliegend davon gesprochen ist, dass jede der separaten Baugruppen eine integrierte aktive Luftkühlung beinhaltet, so handelt es sich dabei vorzugsweise um eine wenigstens einen Lüfter aufweisende Luftkühlung, bei der die zu kühlenden Elemente des jeweiligen Spannungsverstärkerzweigs durch einen definierten Kühlluftstrom gekühlt werden, der z.B. in geeigneten Luftführungskanälen innerhalb eines Gehäuses geleitet wird. Eine solchermaßen aktive Luftkühlung kann gegebenenfalls durch weitere Kühlelemente unterstützt sein, wie z.B. durch oberflächenvergrößernde Kühlkörper im Kühlluftkanal, aktiv kühlende Peltier- oder PTC-Elemente in Bereichen mit besonders hoher Wärmeentwicklung, etc.

Soweit im Rahmen der vorliegenden Erfindung die Prüf-, spannung unter Verwendung von zwei Spannungsverstärkerzweigen erzeugt wird, von denen ein erster zur Erzeugung der positiven Spannungshalbwellen der Prüfspannung und ein zweiter zur Erzeugung der negativen Spannungshalbwellen der Prüfspannung dient, so ist der prinzipielle Aufbau hierfür geeigneter (Hoch-)Spannungsverstärker aus dem Stand der Technik bekannt.

Hierzu sei beispielsweise verwiesen auf die DE 19513441 C5, welche eine Schaltungsanordnung zur Erzeugung einer Prüfspannung betrifft. Dabei wird mittels zwei als Hochspannungsquellen fungierenden Verstärkerzweigen mit je einem Schaltnetzteil, einem Hochspannungstransformator, einer Gleichrichterschaltung und einer diesen nachgeschalteten elektronisch regelbaren Hochspannungsschalteranordnung ein Prüfling bzw. Messobjekt unter Bereitstellung einer Prüfspannung mit vorgebbarem Verlauf definiert auf- und entladen. Insoweit dient der erste Verstärkerzweig zur Bereitstellung der positiven Spannungshalbwellen der Prüfspannung und der zweite Verstärkerzweig zur Erzeugung der negativen Spannungshalbwellen der Prüfspannung, welche z.B. sinusförmig sein und die vorliegend beanspruchte Spannungsamplitude und Leistung haben kann.

Ferner ist z.B. auch aus der Veröffentlichung "Discharge measurements in cables using a solid state 30 kV bipolar low frequency generator", S.J. Kearly, R.R. MacKinlay Fifth International Conference on Dielectric Materials, Measurements and Applications, 1988, S. 171-174, eine Schaltungsanordnung bekannt, die sich ohne Probleme im vorliegenden Leistungsbereich mit einer Spannungsamplitude von wenigstens 100kv betreiben lässt und bei welcher aus einer positiven bzw. negativen Gleichspannung im kV-Bereich mittels einer geeigneten (als steuerbare Stromquelle fungierenden) Halbleiterschalteranordnung eine in ihrem Verlauf regelbare Prüfspannung zur definierten Auf- und Entladung eines Messobjekts erzeugt wird. Auch auf Basis dieses Prinzips lässt sich somit ein erster Spannungsverstärkerzweig zur Erzeugung der positiven Spannungshalbwellen und ein zweiter Spannungsverstärkerzweig zur Erzeugung der negativen Spannungshalbwellen einer Prüfspannung realisieren.

Weiterhin kann im Rahmen der vorliegenden Erfindung für die jeweiligen Spannungsverstärkerzweige auch eine Schaltungsanordnung Verwendung finden, die zum Anschluss an eine Netzspannung eingerichtet ist und hieraus zunächst mittels eines einen Modulator beinhaltenden Schaltnetzteils die positiven (oder negativen) Spannungshalbwellen der Netzspannung in einem ersten Schritt auf eine Wechselspannung mit einer hohen Frequenz von z.B. 70 kHz bei z.B. 370 V absoluter Spannungsamplitude moduliert und diese anschließend mittels eines dem Schaltnetzteil nachgeschalteten Transformators auf eine Spannungsamplitude von z.B. 8 kV (bei noch immer 70 kHz Frequenz) transformiert. Anschließend kann hieraus mittels einer geeigneten Kaskadenschaltung aus Kondensatoren und Gleichrichtern eine Gleichspannung von z.B. 200 kV erzeugt werden, wobei ggfs. bereits mit einer solchen Kaskadenschaltung durch geeignete Schaltung oder Regelung eine Hochspannung variabler Amplitude erzeugt werden könnte, um spätere Schaltungsverluste zu reduzieren oder minimieren. Dieser Kaskadenschaltung kann dann in dem betreffenden Spannungsverstärkerzweig eine (hochspannungsseitig angeordnete und elektronisch steuer- und/oder regelbare) Halbleiterschalteranordnung folgen, wie diese z.B. in der vorgenannten Veröffentlichung von Kearly und MacKinlay beschrieben ist, welche insbesondere unter Auswertung des am Messobjekt gemessenen Prüfstroms und/oder der Prüfspannung die durch die vorgeschalteten Komponenten des Spannungsverstärkerzweigs erzeugte positive oder negative Hochspannung in positive bzw. negative Spannungshalbwellen mit einer absoluten Amplitude von ca. 200 kV bei einer Frequenz von z.B. 0,1 Hz wandelt. Dieser Halbleiterschaltungsanordnung kann gegebenenfalls bzw. vorteilhaft noch eine Schaltung zur Dämpfung von Störungen, also zur Glättung der gewünschten Ausgangsspannung, nachgeschaltet sein. Selbstverständlich sind dabei der die positiven Spannungshalbwellen und der die negativen Spannungshalbwellen bereitstellende Spannungsverstärkerzweig auf geeignete Weise (z.B. mittels von einer zentralen Steuereinheit erzeugten Synchronisierungssignalen) zu synchronisieren, so dass die in den verschiedenen Verstärkerzweigen erzeugten positiven und negativen Spannungshalbwellen (durch wechselweise Beaufschlagung des Messobjekts mit den verschiedenen Spannungshalbwellen) die gewünschte Prüfspannung bilden.

Die den Prüfstrom und die Prüfspannung messende Messschaltung eines erfindungsgemäßen Hochspannungsprüfgeräts kann in fachüblicher Weise ausgestaltet sein, wobei z.B. der durch den Prüfling fließende Strom ggfs. auch innerhalb der jeweiligen Verstärkerzweige gemessen werden kann, so dass ein die Messung des Prüfstroms betreffender Teil der Messschaltung - wie im Übrigen ggfs. auch ein die Messung der Prüfspannung betreffender Teil der Messschaltung - ggfs. in die die jeweiligen Verstärkerzweige beinhaltenden Baugruppen integriert sein kann.

Im Rahmen einer ersten Weiterbildung der vorliegenden Erfindung ist vorgesehen, dass die unter Zusammenwirkung der in separaten Baugruppen verbauten Spannungsverstärkerzweige erzeugte Prüfspannung eine VLF(Very-Low-Frequency)-Wechselspannung mit einer Frequenz im Bereich zwischen 0,01 Hz und 1 Hz ist. Derartige VLF-Prüfgeräte, die besonders bevorzugt eine Prüfspannung mit einer Frequenz von 0,1 Hz erzeugen, weisen - wegen der kontinuierlichen Bereitstellung der Prüfspannung und der in den Verstärkerzweigen kontinuierlich erfolgenden Steuer- bzw. Regelungseingriffe - ein besonders hohen Maß an Abwärme auf, welches im Rahmen der vorliegenden Erfindung besonders effektiv, nämlich für jeden Verstärkerzweig separat, abgeführt werden kann. Eine - z.B. in eine zentrale Steuereinheit des Hochspannungsprüfgeräts integrierte - Auswerteeinheit des Geräts kann vorteilhaft auch zur Bestimmung des Verlustfaktors des zu prüfenden Messobjekts eingerichtet sein.

Weiterhin ist im Rahmen der vorliegenden Erfindung bevorzugt vorgesehen, dass die Mittel zur Erzeugung der Prüfspannung eine gerade Anzahl n, mit n ≥ 4, an Spannungsverstärkerzweigen aufweist, wobei jeder Spannungsverstärkerzweig in einer separaten Baugruppe mit integrierter aktiver Luftkühlung verbaut ist und wobei das Hochspannungsprüfgerät unter geeigneter Synchronisierung der Spannungsverstärkerzweige derart eingerichtet ist, dass die erste Hälfte (= n/2) der Spannungsverstärkerzweige zur Erzeugung der positiven Spannungshalbwellen der Prüfspannung und die zweite Hälfte (= n/2) der Spannungsverstärkerzweige zur Erzeugung der negativen Spannungshalbwellen der Prüfspannung zusammenwirken.

Aufgrund der Ausführung einzelner Spannungsverstärkerzweige in separaten Baugruppen, kann im Rahmen der vorliegenden Erfindung in besonders einfacher Weise die mit zwei Spannungsverstärkerzweigen bereitstellbare Ausgangsleistung vervielfacht werden, indem sowohl zur Erzeugung der positiven Spannungshalbwellen der Prüfspannung als auch zur Erzeugung der negativen Spannungshalbwellen der Prüfspannung jeweils eine identische Mehrzahl (n/2, mit n ≥ 4) an - vorzugsweise identischen - Spannungsverstärkerzweigen Verwendung finden.

Der Anschluss des Messobjekts kann dann erkennbar so erfolgen, dass die jeweiligen Spannungsverstärkerzweige das Messobjekt in Parallelschaltung mit der von dem jeweiligen Spannungsverstärkerzweig erzeugten Hochspannung beaufschlagen, womit ersichtlich - abhängig von der Anzahl der zur Verwendung kommenden Spannungsverstärkerzweige - die elektrische Leistung des Hochspannungsprüfgeräts (im Vergleich zum Stand der Technik) vervielfacht werden kann. Da vorliegend jeder Verstärkerzweig in einer separaten Baugruppe mit eigener aktiver Luftkühlung verbaut ist, bleibt die erfindungsgemäß ermöglichte Leistungssteigerung ohne nachteilige Auswirkungen auf das Kühlkonzept des erfindungsgemäßen Hochleistungs-Hochspannungsprüfgeräts.

Im Übrigen ergibt sich erfindungsgemäß die Möglichkeit der Realisierung eines modulartig aufgebauten Hochspannungsprüfgeräts, indem gemäß einer weiteren bevorzugten Ausgestaltung der vorliegenden Erfindung vorgesehen sein kann, dass das Hochspannungsprüfgerät derart gestaltet und eingerichtet ist, dass den Mitteln zur Erzeugung der Prüfspannung bis hin zu einer systembedingten Höchstzahl an Spannungsverstärkerzweigen jeweils wenigstens ein weiteres Paar an Spannungsverstärkerzweigen hinzugefügt werden kann, von dem stets ein erster Spannungsverstärkerzweig zur Erzeugung der positiven Spannungshalbwellen der Prüfspannung und ein zweiter Spannungsverstärkerzweig zur Erzeugung der negativen Spannungshalbwellen der Prüfspannung beiträgt.

Mit anderen Worten kann im Rahmen der vorliegenden Erfindung also ein Gerätekonzept verwirklicht werden, bei dem z.B. das Hochspannungsprüfgerät in einer ersten Konfiguration zunächst mit (genau) einem Paar an Spannungsverstärkerzweigen (zur Erzeugung der positiven und negativen Spannungshalbwellen) betrieben werden kann, wobei das Prüfgerät durch einfaches Hinzufügen bzw. einfachen Anschluss weiterer Paare an Spannungsverstärkerzweigen (also jeweils eines ersten Spannungsverstärkerzweigs zur Erzeugung positiver Spannungshalbwellen und eines zweiten Spannungsverstärkerzweigs zur Erzeugung negativer Spannungshalbwellen) zum Zwecke der Erhöhung der Ausgangsleistung erweiterbar (und wieder rückbaubar) ist. Die Anwender solcher Geräte werden somit in die Lage versetzt, ein erfindungsgemäßes Hochspannungsprüfgerät bedarfsweise an die für eine bestimmte Messung benötigte Ausgangsleistung anzupassen, indem das Gerät am Aufstellort einfach mit der hierfür benötigten Anzahl an Verstärkerzweigen installiert werden kann. Dabei ergeben sich im Übrigen wiederum keinerlei Verschlechterungen im Hinblick auf die Transportabilität des Hochspannungsprüfgeräts und/oder Probleme mit der Gerätekühlung. Es muss lediglich eine gegenüber der Mindestanzahl von zwei (die jeweiligen Verstärkerzweige beinhaltenden) Baugruppen vergrößerte Anzahl an Baugruppen transportiert und installiert werden. Die systembedingte Höchstzahl an in einem erfindungsgemäßen Hochspannungsprüfgerät maximal verwendbaren Spannungsverstärkerzweigen kann z.B. bei n = 6, 8, 10, 12, 14, 16, 18, 20, 22, 24 oder noch höher liegen.

Wenn man davon ausgeht, dass mit den aus dem Stand der Technik bekannten Hochspannungsprüfgeräten mit genau einem Spannungsverstärkerzweigpaar bereits elektrische Ausgangsleistungen von ca. 8 kW bei einer VLF-Prüfspannung mit 200 kV Spannungsamplitude erzielbar ist, so lässt sich diese Ausgangsleistung im Rahmen der vorliegenden Erfindung (bei gleicher Spannungsamplitude wegen der gegebenen Parallelschaltung) bei Verwendung von z.B. 3 - 10 Spannungsverstärkerzweigpaaren (entsprechend n = 6 - 20) in einfacher Weise auf 24 - 80 kW erhöhen.

Von besonderem Vorteil erweist sich ferner, wenn das Hochspannungsprüfgerät eine zentrale Steuereinheit aufweist, die ebenfalls in einer separaten Baugruppe verbaut ist und an welcher eine gerade Anzahl an Anschlusselementen zum Anschluss der wenigstens zwei - je einen Spannungsverstärkerzweig beinhaltenden - Baugruppen vorgesehen ist.

Soweit vorliegend von dem Anschluss der die Spannungsverstärkerzweige beinhaltenden Baugruppen an die zentrale Steuereinheit gesprochen wird, so kann es sich hierbei um einen mechanischen und/oder elektrischen Anschluss handeln, wobei ggfs. zum Anschluss jeder Baugruppe auch jeweils ein erstes Anschlusselement für die Herstellung einer mechanischen Verbindung der betreffenden Baugruppe mit dem Gehäuse der zentralen Steuereinheit und ein zweites Anschlusselement zur Herstellung einer elektrischen Verbindung vorgesehen sein kann. Aus Sicherheitsgründen sollte dabei vorteilhaft auf eine gute mechanische Kopplung der verschiedenen Baugruppen Wert gelegt werden.

Die Herstellung einer elektrischen Verbindung zwischen den die einzelnen Verstärkerzweige beinhaltenden Baugruppen und der zentralen Steuereinheit ist insbesondere dann notwendig, wenn - was in einer abermals bevorzugten Weiterbildung der Erfindung vorgesehen ist - an der die zentrale Steuereinheit beinhaltenden Baugruppe ferner ein Anschlusselement zum Anschluss und zur elektrischen Kontaktierung des Messobjekts bzw. Prüflings vorgesehen ist.

Ferner kann vorteilhaft eine mittels einer geeigneten Verbindung herstellbare Kommunikationsleitung zwischen der zentralen Steuereinheit und den jeweiligen Baugruppen bzw. darin integrierter lokaler Steuereinheiten für die jeweiligen Spannungsverstärkerzweige vorgesehen sein, über die z.B. mittels eines geeigneten Synchronisierungssignals die Synchronisierung der verschiedenen Spannungsverstärkerzweige erfolgen kann und/oder über die z.B. in bidirektionaler Verbindung eine Kommunikation zwischen lokalen Steuereinheiten der verschiedenen Spannungsverstärkerzweige und der zentralen Steuereinheit realisiert werden kann, um z.B. unter Bereitstellung einer Plug-and-Play-Funktionalität mittels der zentralen Steuereinheit automatisch erkennen zu können, welche und wie viele Spannungsverstärkerzweige im Rahmen der Erzeugung der Prüfspannung zusammenwirken. Ferner können die einzelnen Baugruppen mit den Spannungsverstärkerzweigen vorteilhaft die gegebenenfalls in der betreffenden Baugruppe ermittelten Messwerte zu Prüfstrom und/oder Prüfspannung zur weiteren Auswertung an die zentrale Steuereinheit übergeben. Die Kommunikation zwischen den verschiedenen Steuereinheiten könnte jedoch z.B. auch drahtlos (z.B. via W-LAN, Bluetooth oder sonstige Funkübertragungstechniken) erfolgen, wenn in die beteiligten Baugruppen geeignete Kommunikationsmodule verbaut werden.

Besonders bevorzugt ist im Rahmen der vorliegenden Erfindung vorgesehen, dass die die zentrale Steuereinheit beinhaltende Baugruppe ein auf einem Untergrund abstellbares und sich turmartig in vertikaler Richtung erstreckendes Gehäuse umfasst, an dessen seitlichem Umfang, vorzugsweise in dessen oberen Endbereich, die wenigstens zwei Anschlusselemente zum Anschluss der je einen Spannungsverstärkerzweig beinhaltenden Baugruppen vorgesehen sind. Falls systembedingt ein bestimmte größere Anzahl an maximal an das Hochspannungsprüfgerät anschließbaren Baugruppen mit darin integrierten Spannungsverstärkerzweigen vorgesehen ist, so entspricht die Zahl der Anschlusselemente, welche an der die zentrale Steuereinheit beinhaltenden Baugruppe vorgesehen sind, vorteilhaft dieser Anzahl, wobei hier ggfs. alternativ auch an die Bereitstellung von verschiedenen, an die jeweils konkret verwendete Anzahl an Spannungsverstärkerzweigen angepasste Adapterplatten mit einer entsprechenden Anzahl an Anschlusselementen gedacht werden könnte.

Vorteilhaft sind die betreffenden Anschlusselemente gleichmäßig über den Umfang des Gehäuses verteilt, um einen größtmöglichen Abstand zwischen den an die einzelnen Anschlusselemente anzuschließenden Baugruppen zu gewährleisten zu können.

Ebenfalls denkbar ist jedoch, dass die die zentrale Steuereinheit beinhaltende Baugruppe und die die jeweiligen Spannungsverstärkerzweige beinhaltenden Baugruppen vollkommen separat und voneinander entfernt aufstellbar sind und eine zum Betrieb des Hochspannungsprüfgeräts gegebenenfalls erforderliche Kontaktierung der verschiedenen Elemente des Hochspannungsprüfgeräts ausschließlich über geeignete Verbindungskabel erfolgt.

Die die einzelnen Spannungsverstärkerzweige beinhaltenden Baugruppen weisen in abermals bevorzugter Weiterbildung der Erfindung jeweils einen ersten und zweiten Gehäuseabschnitt auf, wobei der erste Gehäuseabschnitt auf einem Untergrund abstellbar ist und sich (wie das Gehäuse der die zentrale Steuereinheit beinhaltenden Baugruppe) turmartig in vertikaler Richtung erstreckt und wobei der zweite Gehäuseabschnitt, der sich vorteilhaft in im Wesentlichen (oder exakt) horizontaler Richtung erstreckt, mit einem ersten Ende an dem ersten Gehäuseabschnitt, vorzugsweise in dessen oberen Endbereich, befestigt und mit einem zweiten Ende an der die zentrale Steuereinheit beinhaltenden Baugruppe anschließbar ist. Diese beiden Gehäuseabschnitte können gegebenenfalls lösbar miteinander verbunden sein, was deren Transport nochmals vereinfacht.

Die den jeweiligen Spannungsverstärkerzweig bildende Elektronik kann auf die beiden Gehäuseabschnitte verteilt sein, die bevorzugt beide von der durch die aktive Luftkühlung transportierte Kühlluft durchströmt werden.

Hierzu kann vorteilhaft vorgesehen sein, dass sowohl im ersten als auch im zweiten Gehäuseabschnitt der einen Spannungsverstärkerzweig beinhaltenden Baugruppe untereinander verbundene Luftführungskanäle ausgebildet sind, wobei im ersten Gehäuseabschnitt, vorzugsweise bodennah, eine Eintrittsöffnung für die Kühlluft und im zweiten Gehäuseabschnitt, vorzugsweise in dessen vom ersten Gehäuseabschnitt entfernten Endbereich, eine Austrittsöffnung für die (erwärmte) Kühlluft vorgesehen ist.

Die zweiteilige Gehäusegestaltung mit einem vertikal und einem horizontal verlaufenden Gehäuseabschnitt stellt dabei sicher, dass die frische Kühlluft hinreichend weit entfernt von der Austrittsöffnung für die erwärmte Kühlluft in das Gehäuse eintreten kann, wo sie in thermodynamisch günstiger Weise zunächst nach oben geführt und schließlich zum Zwecke der Passage durch den horizontalen Gehäuseabschnitt umgelenkt wird.

Als besonders vorteilhaft erweist es sich dabei, wenn die Kühlluft im Bereich der im ersten Gehäuseabschnitt vorgesehenen Eintrittsöffnung mittels eines Lüfters angesaugt wird.

Da bei einem erfindungsgemäßen Hochspannungsprüfgerät vorgesehen sein kann, dass in dem zweiten, horizontal und vorteilhaft mit Abstand zum Untergrund verlaufenden Gehäuseabschnitt der die Spannungsverstärkerzweige beinhaltenden Baugruppen insbesondere auch solche (Hochspannungs-)Elektronikkomponenten angeordnet sein können, die einer besonders effektiven Kühlung bedürfen, erweist es sich im Rahmen der vorliegenden Erfindung zur Optimierung der Kühlleistung der in die jeweilige Baugruppe integrierten Luftkühlung als außerordentlich zweckmäßig, wenn der wenigstens eine Lüfter oder eine den wenigstens einen Lüfter steuernde Steuereinheit dazu eingerichtet ist, bedarfsweise oder in vorgebbaren Zeitintervallen eine Umkehrung der zu Kühlzwecken durch die Baugruppe geführten Luftströmung herbeizuführen.

Und schließlich ist im Rahmen der vorliegenden Erfindung vorteilhaft vorgesehen, dass die Messschaltung zumindest teilweise in der die zentrale Steuereinheit beinhaltenden Baugruppe angeordnet ist. Hierbei kann insbesondere ein Spannungsteiler zur Verwendung kommen, mit dem - innerhalb der die zentrale Steuereinheit bildenden Baugruppe - die am Messobjekt anliegende Prüfspannung gemessen wird.

Nachfolgend wird ein Ausführungsbeispiel der Erfindung anhand der Zeichnung näher erläutert. Dabei zeigt
- Fig. 1: eine schematische Darstellung eines Ausführungsbeispiel eines erfindungsgemäßen Hochleistungs-Hochspannungsprüfgeräts mit zwei Spannungsverstärkerzweigen,
- Fig. 2: eine perspektivische Ansicht eines Ausführungsbeispiels eines erfindungsgemäßen Hochleistungs-Hochspannungsprüfgeräts, und
- Fig. 3: eine weitere Darstellung zur Veranschaulichung der aktiven Luftkühlung der die Spannungsverstärkerzweige beinhaltenden Baugruppen.

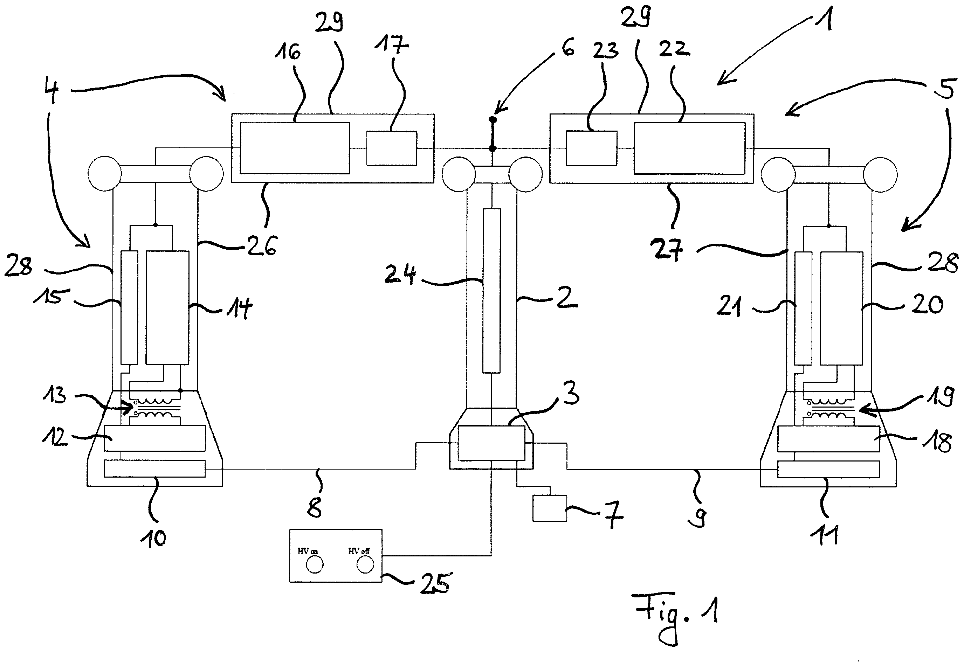

Fig. 1 zeigt in schematischer Darstellungsweise ein erfindungsgemäßes Hochspannungsprüfgerät 1, welches eine in einer separaten Baugruppe 2 verbaute zentrale Steuereinheit 3 aufweist.

Die Mittel zur Erzeugung der Prüfspannung (Wechselspannung mit einer absoluten Amplitude von wenigstens 100 kV bei einer Leistung von größer als 1 kW) sind gebildet durch (wenigstens) zwei Spannungsverstärkerzweige 4, 5, von denen der in Fig. 1 links dargestellte Spannungsverstärkerzweig 4 zur Erzeugung der positiven Spannungshalbwellen der Prüfspannung und der in Fig. 1 rechts dargestellte Spannungsverstärkerzweig 5 zur Erzeugung der negativen Spannungshalbwellen der Prüfspannung dient.

Die Prüfspannung selbst liegt dann an einem Anschluss 6 für ein zu prüfendes Messobjekt (z.B. ein nicht dargestelltes Hochspannungskabel) an, wobei der Anschluss 6 vorliegend an der die zentrale Steuereinheit 3 beinhaltenden Baugruppe 2 ausgebildet ist. Über den Anschluss 6 wird das zu prüfende Messobjekt wechselweise mit den von beiden Spannungsverstärkerzweigen 4, 5 bereitgestellten (positiven und negativen) Spannungshalbwellen beaufschlagt, so dass am Ausgang 6 zur Prüfung des Messobjekts insgesamt eine (z.B. sinusförmige) Wechselspannung als Prüfspannung bereitgestellt wird, die vorzugsweise als VLF(Very-Low-Frequency)-Spannung im Frequenzbereich zwischen 0,01 Hz und 1 Hz liegt.

Ferner ist an der die zentrale Steuereinheit 3 beinhaltenden Baugruppe 2 ein Anschluss für ein externes Stromversorgungsnetz 7 vorgesehen, wobei die Netzspannung unter Verwendung geeigneter Leitungen 8, 9 zu den Spannungsverstärkerzweigen 4, 5 geführt wird.

Die zentrale Steuereinheit 3 des Hochspannungsprüfgeräts 1 steht mit lokalen Steuereinheiten 10, 11 der verschiedenen Spannungsverstärkerzweige 4, 5 in bevorzugt bidirektionaler Kommunikation, insbesondere um die mit den verschiedenen Spannungsverstärkerzweigen 4, 5 zu erzeugenden Spannungshalbwellen der Prüfspannung unter Aussendung geeigneter Synchronisierungssignale miteinander zu synchronisieren, wobei die betreffende Kommunikation ggfs. drahtlos realisiert sein kann. Die lokalen Steuereinheiten 10, 11 dienen insbesondere zur Steuerung und/oder Regelung der in dem jeweiligen Spannungsverstärkerzweig 4, 5 verbauten Komponenten.

In dem in Fig. 1 links dargestellten Spannungsverstärkerzweig 4 werden zunächst mittels eines einen Modulator beinhaltenden Schaltnetzteils 12 und eines geeignet eingerichteten Transformators 13 die positiven Spannungshalbwellen der Netzspannung (z.B. 230 V bei 60 Hz) in eine im Vergleich zur Frequenz der Netzspannung hochfrequente Wechselspannung positiven Vorzeichens, vorliegend mit einer Amplitude von ca. 370 V bei einer Frequenz von 70 kHz, gewandelt. Eine dem Transformator 13 nachgeschaltete Kaskadenschaltung 14, die in üblicher Bauart aus Gleichrichtern und Kondensatoren aufgebaut sein kann, wandelt die am Transformator 13 ausgangsseitig bereitgestellte Wechselspannung in eine Gleichspannung konstanter Höhe von vorliegend + 200 kV, wobei mittels eines zur Kaskadenschaltung 14 parallel geschalteten Spannungsteilers 15 die Höhe der an der Kaskadenschaltung 14 ausgangsseitig anliegenden Hochspannung abgegriffen und z.B. mittels einer in der lokalen Steuereinheit 10 enthaltenen Messvorrichtung gemessen werden kann. Hierdurch kann durch geeignete Steuerung oder Regelung die an der Kaskadenschaltung 14 ausgangsseitig bereitgestellte Hochspannung ggfs. auch mit variabler Amplitude gestellt oder geregelt werden, um die wärmeerzeugenden Schaltverluste in der im Verstärkerzweig 4 der Kaskadenschaltung 14 nachgeschalteten Hochspannungsschalteranordnung 16 zu reduzieren bzw. minimieren. Mittels einer der Kaskadenschaltung 14 nachgeschalteten Hochspannungsschalteranordnung 16 wird sodann im Spannungsverstärkerzweig 4 die an der Kaskadenschaltung 14 ausgangsseitig bereitgestellte Hochspannung derart in positive Spannungshalbwellen einer Wechselspannung mit Amplituden von wenigstens 100 kV gewandelt, dass letztlich mittels des Spannungsverstärkerzweigs 4 die - zeitlich versetzten - positiven Spannungshalbwellen der Prüfspannung bereitgestellt werden. In dem vorliegenden Ausführungsbeispiel ist der Hochspannungsschalteranordnung 16 noch eine Strommessvorrichtung 17 nachgeschaltet, wobei der dabei ermittelte Strom ersichtlich durch das - am Anschluss 6 der die zentrale Steuereinheit 3 beinhaltenden Baugruppe 2 angeschlossene - Messobjekt fließt und somit den (durch den links dargestellten Spannungsverstärkerzweig 4 verursachten) Prüfstrom im Messobjekt entspricht. Ggfs. könnte der Hochspannungsschalteranordnung 16 noch eine (nicht dargestellte) Schaltung zur Dämpfung bzw. Eliminierung von Störungen, also zur Glättung der im Spannungsverstärkerzweig 4 erzeugten Spannungshalbwellen, nachgeschaltet sein.

Der in Fig. 1 rechts dargestellte Spannungsverstärkerzweig 5, mit welchem bei der Hochspannungsprüfung eines Messobjekts die negativen Spannungshalbwellen der Prüfspannung bereitgestellt werden, ist im Wesentlichen baugleich zu dem in Fig. 1 links dargestellten Spannungsverstärkerzweig 4 aufgebaut. Er weist in entsprechender Anordnung ebenso eine lokale Steuereinheit 11, ein einen Modulator beinhaltendes Schaltnetzteil 18, einen Transformator 19, eine Kaskadenschaltung 20 mit hierzu parallel geschaltetem Spannungsteiler 21 zur Messung der ausgangsseitig an der Kaskadenschaltung 20 bereitgestellten Hochspannung, eine Hochspannungsschalteranordnung 22 und eine Strommessvorrichtung 23 auf.

Der Unterschied zwischen den beiden Spannungsverstärkerzweigen 4, 5 besteht darin, dass mit dem in Fig. 1 rechts dargestellten Spannungsverstärkerzweig 5 die um 180° phasenversetzten negativen Spannungshalbwellen der Prüfspannung erzeugt werden, so dass insgesamt - bei wechselweiser Beaufschlagung des am Anschluss 6 angeschlossenen Messobjekts mit den in den verschiedenen Spannungsverstärkerzweigen 4, 5 erzeugten positiven und negativen Spannungshalbwellen - die gewünschte Prüfspannung bereit gestellt wird. Dabei kann durch geeignete Schaltung von - in die Hochspannungsschalteranordnungen 16, 22 der jeweiligen Spannungsverstärkerzweige 4, 5 integrierte - Hochspannungsschalter (nicht dargestellt) z.B. dafür Sorge getragen werden, dass das Messobjekt für die Dauer der positiven bzw. negativen Spannungshalbwelle der Prüfspannung ausschließlich mit dem (oder den) betreffenden Spannungsverstärkerzweigen verbunden ist.

Ersichtlich ist es von Vorteil, wenn die Strommessvorrichtungen 17, 23 dazu eingerichtet sind, die im Rahmen der Strommessung gewonnenen Messdaten an die lokale Steuereinheit des jeweiligen Spannungsverstärkerzweigs und/oder an die zentrale Steuereinheit 3 des Hochspannungsprüfgeräts 1 zu übermitteln.

In der die zentrale Steuereinheit 3 beinhaltenden und den Anschluss für das Messobjekt aufweisenden Baugruppe 2 ist schließlich noch eine (einen Spannungsteiler beinhaltende) Vorrichtung 24 zur Messung der am Messobjekt anliegenden Prüfspannung vorgesehen. Vorliegend ist also die Messschaltung zur Messung der an dem (am Anschluss 6 anzuschließenden Messobjekt) verteilt auf die verschiedenen Spannungsverstärkerzweige 4, 5 und die die zentrale Steuereinheit 3 beinhaltende Baugruppe 2 angeordnet.

Und schließlich ist an der zentralen Steuereinheit 3 noch ein z.B. durch einen Computer mit geeigneter Software gebildetes Bedienmodul 24 angeschlossen, mit welchem die Hochspannungserzeugung ein- und ausgeschaltet und ggfs. weitere Einstellungen (z.B. zur gewünschten Kurvenform und/oder Frequenz der Prüfspannung) getätigt werden und ggfs. die Messergebnisse der Strommessvorrichtungen 17, 23 und der Spannungsmessvorrichtung 24 ausgelesen werden können. Besagtes Bedienmodul 24 kann hierzu, wie dargestellt, an der zentralen Steuereinheit angeschlossen sein oder ggfs. auch drahtlos mit der zentralen Steuereinheit kommunizieren. Ferner können im Rahmen der Prüfung eines Messobjekts mittels der zentralen Steuereinheit 3 oder dem Bedienmodul 24 vorteilhaft auch weitere Auswertungen, insbesondere die Ermittlung des Verlustfaktors eines Messobjekts, vorgenommen und die hierbei ermittelten Daten ausgegeben, gespeichert und/oder weitergeleitet werden.

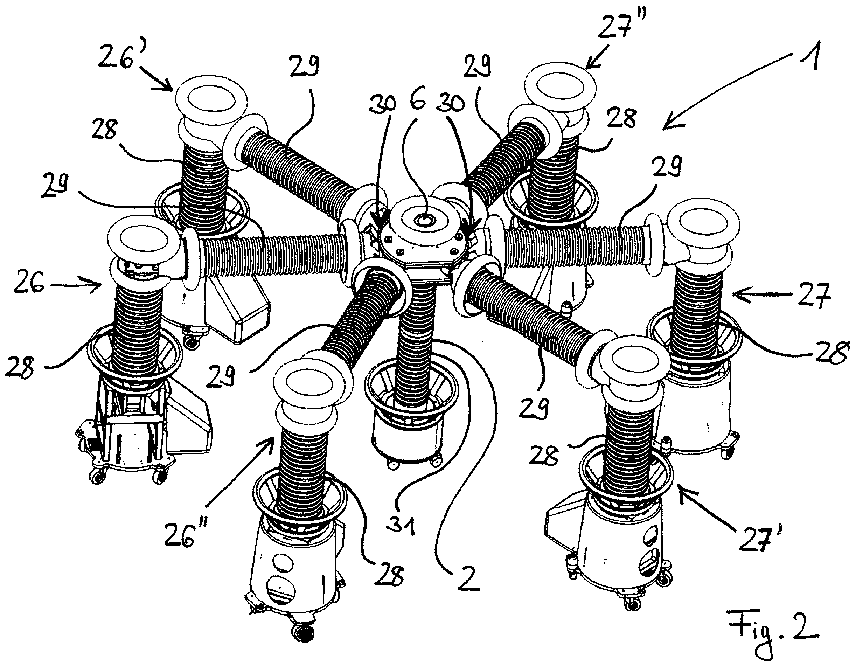

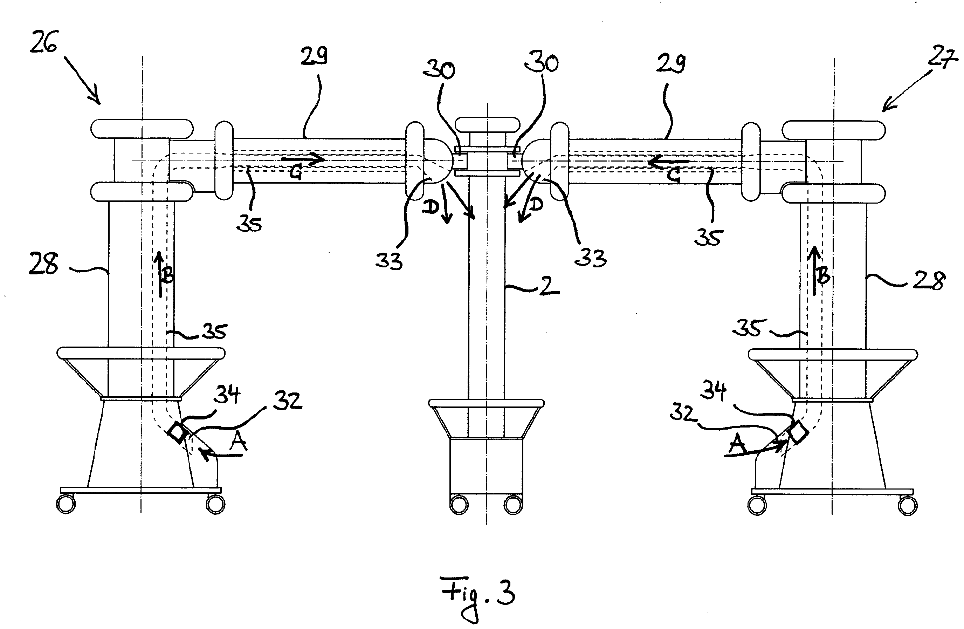

Bereits die schematische Darstellung aus Fig. 1 lässt erkennen, dass die beiden Spannungsverstärkerzweige 4, 5 jeweils in separaten (am Aufstellungsort geeignet miteinander zu verbindenden) Baugruppen 26, 27 verbaut sind, wobei jede Baugruppe 26, 27 einen vertikal und einen horizontal verlaufenden Gehäuseabschnitt 28, 29 aufweist, was nachfolgend anhand von Fig. 2 noch näher erläutert wird. Jede - je einen Spannungsverstärkerzweig 4, 5 beinhaltende - Baugruppe 26, 27 weist zudem eine in dessen Gehäuse bzw. die Gehäuseabschnitte 28, 29 der betreffenden Baugruppe 26, 27 integrierte aktive Luftkühlung auf, wie dies nachfolgend anhand von Fig. 3 erläutert ist.

Fig. 2 zeigt ein Ausführungsbeispiel eines erfindungsgemäßen Hochleistungshochspannungsprüfgeräts 1 in perspektivischer Ansicht. Dieses weist eine zentral angeordnete Baugruppe 2 auf, in welcher die zentrale Steuereinheit des Hochspannungsprüfgeräts verbaut ist und welche einen Anschluss 6 für das mit dem erfindungsge-, mäßen Hochspannungsprüfgerät 1 zu prüfende Messobjekt aufweist. Ferner weist das Hochspannungsprüfgerät 1 vorliegend insgesamt sechs separate Baugruppen 26, 26', 261" 27, 27', 27", welche über geeignete Anschlusselemente 30 an die die zentrale Steuereinheit 3 beinhaltende Baugruppe 2 angeschlossen sind.

Dabei beinhalten die drei in Fig. 2 links dargestellten Baugruppen 26, 26', 26" je einen Spannungsverstärkerzweig zur Erzeugung der positiven Spannungshalbwellen der Prüfspannung in Entsprechung des in Fig. 1 links dargestellten Spannungsverstärkerzweigs 4 und die drei in Fig. 2 rechts dargestellten Baugruppen 27, 27', 27" je einen Spannungsverstärkerzweig zur Erzeugung der negativen Spannungshalbwellen der Prüfspannung in Entsprechung des in Fig. 1 rechts dargestellten Spannungsverstärkerzweigs 5.

Die - im Rahmen der Hochspannungserzeugung geeignet zu synchronisierenden - Spannungsverstärkerzweige in den verschiedenen Baugruppen 26, 26', 26" 27, 27', 27" und der an der zentralen Baugruppe 2 vorgesehene Anschluss 6 für das Messobjekt sind parallel verschalten, so dass das Messobjekt stets gleichzeitig von den die jeweils positiven bzw. negativen Spannungshalbwellen der Prüfspannung erzeugenden Spannungsverstärkerzweigen beaufschlagt wird, so dass sich deren jeweilige Ausgangsleistung, die bevorzugt zumindest jeweils paarweise oder insgesamt identisch ist, aufaddiert.

Das in Fig. 2 gezeigte Hochspannungsprüfgerät 1 ist bereits bei Anschluss eines ersten Paars an Spannungsverstärkerzweigen (z.B. durch geeigneten Anschluss der Baugruppen 26, 27 an die zentrale Baugruppe 2) funktionsfähig und kann bei entsprechendem Bedarf sukzessive um je ein weiteres Paar an Spannungsverstärkerzweigen (durch Anschluss der Baugruppen 26'/27' bzw. 26"/27") zum Zwecke der Erhöhung der Ausgangsleistung erweitert werden. Vorliegend liegt die systembedingte Maximalzahl an Spannungsverstärkerzweigen bei n=6 (entsprechend der an der zentralen Baugruppe vorgesehenen Anschlusselemente 30), wobei in anderen Ausführungsbeispielen erfindungsgemäßer Hochspannungsprüfgeräte 1 gegebenenfalls eine deutliche höhere Anzahl an Spannungsverstärkerzweigen anschließbar sein können.

Die die zentrale Steuereinheit beinhaltende Baugruppe 2 umfasst ein auf einem Untergrund abstellbares und sich turmartig in vertikaler Richtung erstreckendes Gehäuse 31, an dessen seitlichem Umfang, vorliegend in dessen oberen Endbereich, die sechs Anschlusselemente 30 zum Anschluss der je einen Spannungsverstärkerzweig beinhaltenden Baugruppen 26, 26', 26", 27, 27', 27" vorgesehen sind. Diese Anschlusselemente dienen vorliegend zur Herstellung einer guten mechanischen Anbindung der Baugruppen 26, 26', 26" 27, 27', 27" an die zentrale Baugruppe 2. Die ebenfalls notwendige elektrische Verbindung der in den jeweiligen Baugruppen 2, 26, 26', 26" 27, 27', 27" verbauten Komponenten kann ggfs. über separate Kabel (nicht dargestellt) erfolgen oder bei geeigneter Ausgestaltungen der Anschlusselemente 30 an der zentralen Baugruppe 2 (und der hierzu korrespondierenden Anschlusselemente an den Baugruppen 26, 26', 26", 27, 27', 27") gleichzeitig mit der mechanischen Verbindung der Baugruppen erfolgen.

Die Gehäuse sämtlicher die Spannungsverstärkerzweige beinhaltenden Baugruppen 26, 26', 26" 27, 27', 27" weisen jeweils einen ersten und zweiten Gehäuseabschnitt 28, 29 auf. Der erste Gehäuseabschnitt 28 ist auf einem Untergrund abstellbar und erstreckt sich turmartig in vertikaler Richtung. Der zweite Gehäuseabschnitt 29, der sich in im Wesentlichen horizontaler Richtung erstreckt, ist mit einem ersten Ende an dem ersten Gehäuseabschnitt 28, nämlich in dessen oberen Endbereich, befestigt und mit einem zweiten Ende an der die zentrale Steuereinheit beinhaltenden Baugruppe 2 anschließbar.

Fig. 3 zeigt in einer schematischen Ansicht ein Beispiel der im Rahmen der vorliegenden Erfindung möglichen Ausgestaltung der aktiven Luftkühlung. Dabei weist jede einen Spannungsverstärkerzweig beinhaltende Baugruppe 26, 27 in ihrem ersten Gehäuseabschnitt 28 eine bodennah angeordnete Eintrittsöffnung 32 für die Kühlluft und in ihrem zweiten Gehäuseabschnitt 29, nämlich in dessen vom ersten Gehäuseabschnitt 28 entfernten Endbereich, eine Austrittsöffnung 33 für die beim Durchgang durch das Gehäuse erwärmte Kühlluft auf. Die frische Kühlluft wird mittels eines Lüfters 34 gemäß Pfeil A angesaugt und durchläuft in geeigneten Kühlluftkanälen 35 die beiden Gehäuseabschnitte 28, 29 gemäß Pfeilen B, C, bevor sie im Bereich der Austrittsöffnung 33 gemäß Pfeil D die betreffende Baugruppe 26, 27 verlässt. Die Kühlluftkanäle 35 grenzen an die zu kühlenden Komponenten der Spannungsverstärkerzweige an bzw. werden durch diese begrenzt. Die Luftkühlung ist derart gestaltet, dass sich bei entsprechendem Bedarf zumindest für kurze Zeit eine Umkehrung der Luftströmung herbeiführen lässt.

## Patentansprüche

1. Hochleistungs-Hochspannungsprüfgerät (1) umfassend
- Mittel zur Erzeugung einer Prüfspannung, wobei die Prüfspannung eine Wechselspannung mit einer Amplitude von wenigstens 100 kV bei einer Leistung von größer als 1 kW ist und wobei die Mittel zur Erzeugung der Prüfspannung wenigstens zwei Spannungsverstärkerzweige (4, 5) aufweisen, von denen ein erster Spannungsverstärkerzweig (4) zur Erzeugung der positiven Spannungshalbwellen der Prüfspannung und ein zweiter Spannungsverstärkerzweig (5) zur Erzeugung der negativen Spannungshalbwellen der Prüfspannung beiträgt, und
- eine Messschaltung (17, 23, 24) zur Messung der an einem Messobjekt anzulegenden Prüfspannung und des hierdurch im Messobjekt verursachten Prüfstroms,
**dadurch gekennzeichnet,**
**dass** jeder Spannungsverstärkerzweig (4, 5) in einer separaten Baugruppe (26, 26', 26", 27, 27', 27") mit integrierter aktiver Luftkühlung (32, 33, 34, 35) verbaut ist.

2. Hochspannungsprüfgerät nach Anspruch 1,
**dadurch gekennzeichnet,**
**dass** die unter Zusammenwirkung der in separaten Baugruppen (26, 26', 26", 27, 27', 27") verbauten Spannungsverstärkerzweige (4, 5) erzeugte Prüfspannung eine VLF(Very-Low-Frequency)-Wechselspannung mit einer Frequenz im Bereich zwischen 0,01 Hz und 1 Hz ist.

3. Hochspannungsprüfgerät nach einem der Ansprüche 1 oder 2,
**dadurch gekennzeichnet,**
**dass** die Mittel zur Erzeugung der Prüfspannung eine gerade Anzahl n, mit n ≥ 4, an Spannungsverstärkerzweigen (4, 5) aufweist, wobei jeder Spannungsverstärkerzweig (4, 5) in einer separaten Baugruppe (26, 26', 26", 27, 27', 27") mit integrierter aktiver Luftkühlung (32, 33, 34, 35) verbaut ist und
wobei das Hochspannungsprüfgerät (1) unter geeigneter Synchronisierung der Spannungsverstärkerzweige (4, 5) derart eingerichtet ist, dass die erste Hälfte (= n/2) der Spannungsverstärkerzweige (4) zur Erzeugung der positiven Spannungshalbwellen der Prüfspannung und die zweite Hälfte (= n/2) der Spannungsverstärkerzweige (5) zur Erzeugung der negativen Spannungshalbwellen der Prüfspannung zusammenwirken.

4. Hochspannungsprüfgerät nach einem der Ansprüche 1 bis 3,
**dadurch gekennzeichnet,**
**dass** das Hochspannungsprüfgerät (1) derart gestaltet und eingerichtet ist, dass den Mitteln zur Erzeugung der Prüfspannung bis hin zu einer systembedingten Höchstzahl an Spannungsverstärkerzweigen (4, 5) jeweils wenigstens ein weiteres Paar (4/5) an Spannungsverstärkerzweigen (4, 5) hinzugefügt werden kann, von dem ein erster Spannungsverstärkerzweig (4) zur Erzeugung der positiven Spannungshalbwellen der Prüfspannung und ein zweiter Spannungsverstärkerzweig (5) zur Erzeugung der negativen Spannungshalbwellen der Prüfspannung beiträgt.

5. Hochspannungsprüfgerät nach einem der vorangehenden Ansprüche,
**dadurch gekennzeichnet,**
**dass** das Hochspannungsprüfgerät (1) eine zentrale Steuereinheit (3) aufweist, die ebenfalls in einer separaten Baugruppe (2) verbaut ist und an welcher eine gerade Anzahl an Anschlusselementen (30) zum Anschluss der wenigstens zwei je einen Spannungsverstärkerzweig (4, 5) beinhaltenden Baugruppen (26, 26', 26", 27, 27', 27") vorgesehen ist.

6. Hochspannungsprüfgerät nach Anspruch 5,
**dadurch gekennzeichnet,**
**dass** an der die zentrale Steuereinheit (3) beinhaltenden Baugruppe (2) ferner ein Anschlusselement (6) zum Anschluss und zur elektrischen Kontaktierung des Messobjekts vorgesehen ist.

7. Hochspannungsprüfgerät nach Anspruch 5 oder 6,
**dadurch gekennzeichnet,**
**dass** die die zentrale Steuereinheit (3) beinhaltende Baugruppe (2) ein auf einem Untergrund abstellbares und sich turmartig in vertikaler Richtung erstreckendes Gehäuse (31) umfasst, an dessen seitlichem Umfang, vorzugsweise in dessen oberen Endbereich, die wenigstens zwei Anschlusselemente (30) zum Anschluss der je einen Spannungsverstärkerzweig (4, 5) beinhaltenden Baugruppen (26, 26', 26", 27, 27', 27") vorgesehen sind.

8. Hochspannungsprüfgerät nach Anspruch 5 oder 6,
**dadurch gekennzeichnet,**
**dass** die die einzelnen Spannungsverstärkerzweige (4, 5) beinhaltenden Baugruppen (26, 26', 26", 27, 27', 27") jeweils einen ersten und zweiten Gehäuseabschnitt (28, 29) aufweisen,
wobei der erste Gehäuseabschnitt (28) auf einem Untergrund abstellbar ist und sich turmartig in vertikaler Richtung erstreckt und
wobei der zweite Gehäuseabschnitt (29), der sich in im Wesentlichen horizontaler Richtung erstreckt, mit einem ersten Ende an dem ersten Gehäuseabschnitt (28), vorzugsweise in dessen oberen Endbereich, befestigt und mit einem zweiten Ende an der die zentrale Steuereinheit (3) beinhaltenden Baugruppe (2) anschließbar ist.

9. Hochspannungsprüfgerät nach Anspruch 8,
**dadurch gekennzeichnet,**
**dass** im ersten und zweiten Gehäuseabschnitt (28, 29) der einen Spannungsverstärkerzweig beinhaltenden Baugruppe untereinander verbundene Luftführungskanäle (35) ausgebildet sind,
wobei im ersten Gehäuseabschnitt (28), vorzugsweise bodennah, eine Eintrittsöffnung (32) für die Kühlluft und im zweiten Gehäuseabschnitt (29), vorzugsweise in dessen vom ersten Gehäuseabschnitt (28) entfernten Endbereich, eine Austrittsöffnung (33) für die Kühlluft vorgesehen ist.

10. Hochspannungsprüfgerät nach Anspruch 9,
**dadurch gekennzeichnet,**
**dass** die Kühlluft im Bereich der im ersten Gehäuseabschnitt (28) vorgesehenen Eintrittsöffnung (32) mittels eines Lüfters (34) angesaugt wird.

11. Hochspannungsprüfgerät nach Anspruch 10,
**dadurch gekennzeichnet,**
**dass** der wenigstens eine Lüfter (34) oder eine den wenigstens einen Lüfter (34) steuernde Steuereinheit dazu eingerichtet ist, bedarfsweise oder in vorgebbaren Zeitintervallen eine Umkehrung der zu Kühlzwecken durch die Baugruppe geführten Luftströmung herbeizuführen.

12. Hochspannungsprüfgerät nach einem der vorangehenden Ansprüche,
**dadurch gekennzeichnet,**
**dass** die Messschaltung (17, 23, 24) zumindest teilweise in der die zentrale Steuereinheit (3) beinhaltenden Baugruppe (2) angeordnet ist.

## Claims

1. A high-power high-voltage test device (1) comprising:
- means for generating a test voltage, wherein the test voltage is an a.c. voltage with an amplitude of at least 100 kV and a power of higher than 1 kW and wherein the means for generating the test voltage have at least two voltage-amplifier branches (4, 5), of which a first voltage-amplifier branch (4) contributes to generating the positive voltage half-waves of the test voltage and a second voltage-amplifier branch (5) contributes to generating the negative voltage half-waves of the test voltage, and
- a measuring circuit (17, 23, 24) for measuring the test voltage to be applied to a measurement object and the test current induced thereby in the measurement object,
**characterized in that** each voltage-amplifier branch (4, 5) is mounted in a separate subassembly (26, 26', 26", 27, 27', 27") with integrated active air cooling (32, 33, 34, 35).

2. The high-voltage test device of claim 1, **characterized in that** the test voltage generated by interaction of the voltage-amplifier branches (4, 5) mounted in separate subassemblies (26, 26', 26", 27, 27', 27") is a VLF (very low frequency) a.c. voltage with a frequency in the range between 0.01 Hz and 1 Hz.

3. The high-voltage test device of one of the claims 1 or 2, **characterized in that** the means for generating the test voltage has an even number n, where n ≥ 4, of voltage-amplifier branches (4, 5), wherein each voltage-amplifier branch (4, 5) is mounted in a separate subassembly (26, 26', 26", 27, 27', 27") with integrated active air cooling (32, 33, 34, 35) and wherein the high-voltage test device (1) is set up with suitable synchronization of the voltage-amplifier branches (4, 5) in such a way that the first half (= n/2) of the voltage-amplifier branches (4) for generation of the positive voltage half waves of the test voltage and the second half (= n/2) of the voltage-amplifier branches (5) for generation of the negative voltage half waves of the test voltage work together.

4. The high-voltage test device of one of the claims 1 to 3, **characterized in that** the high-voltage test device (1) is configured and set up in such a way that, up to a system-limited maximum number of voltage-amplifier branches (4, 5), it is respectively possible to add to the means for generating the test voltage at least one further pair (4/5) of voltage-amplifier branches (4, 5), of which a first voltage-amplifier branch (4) contributes to generation of the positive voltage half waves of the test voltage and a second voltage-amplifier branch (5) to generation of the negative voltage half waves of the test voltage.

5. The high-voltage test device of one of the preceding claims, **characterized in that** the high-voltage test device (1) has a central control unit (3), which is also mounted in a separate subassembly (2) and on which an even number of attachment elements (30) is provided for attachment of the at least two subassemblies (26, 26', 26", 27, 27', 27"), each containing a voltage-amplifier branch (4, 5).

6. The high-voltage test device of claim 5, **characterized in that** an attachment element (6) for attachment and for electrical contacting of the measurement object is further provided on the subassembly (2) containing the central control unit (3).

7. The high-voltage test device of claim 5 or claim 6, **characterized in that** the subassembly (2) containing the central control unit (3) comprises a housing (31), which can be placed on a base and extends tower-like in vertical direction, on the lateral periphery of which, preferably in its upper end region, the at least two attachment elements (30) are provided for attachment of the subassemblies (26, 26', 26", 27, 27', 27") containing one voltage-amplifier branch (4, 5) each.

8. The high-voltage test device of claim 5 or claim 6, **characterized in that** the subassemblies (26, 26', 26", 27, 27', 27") containing the individual voltage-amplifier branches (4, 5) respectively have a first and second housing portion (28, 29), wherein the first housing portion (28) can be placed on a base and extends tower-like in vertical direction, and wherein the second housing portion (29), which extends in substantially horizontal direction, is fastened with a first end to the first housing portion (28), preferably in the upper end region thereof, and can be attached with a second end to the subassembly (2) containing the central control unit (3).

9. The high-voltage test device of claim 8, **characterized in that** air-conveying ducts (35) connected to one another are formed in the first and in the second housing portion (28, 29) of the subassembly containing a voltage-amplifier branch, wherein an inlet opening (32) for the cooling air is provided in the first housing portion (28), preferably near the bottom, and an outlet opening (33) for the cooling air is provided in the second housing portion (29), preferably in its end region removed from the first housing portion (28).

10. The high-voltage test device of claim 9, **characterized in that** the cooling air is sucked in by means of a fan (34) in the region of the inlet opening (32) provided in the first housing portion (28).

11. The high-voltage test device of claim 10, **characterized in that** the control unit controlling at least one fan (34) or a control unit controlling at least one fan (34) is set up to bring about, as needed or at pre-programmable time intervals, reversal of the air stream being conveyed for cooling purposes through the subassembly.

12. The high-voltage test device of one of the preceding claims, **characterized in that** the measuring circuit (17, 23, 24) is disposed at least partly in the subassembly (2) containing the central control unit (3).

## Revendications

1. Appareil de test à haute tension à haute puissance (1) comprenant :
- des moyens pour produire une tension de test, dans lequel la tension de test est une tension alternative avec une amplitude d'au moins 100 kV en présence d'une puissance plus grande que 1 kW et dans lequel les moyens de génération de la tension de test présentent au moins deux branches d'amplificateur de tension (4, 5), desquelles une première branche de d'amplificateur de tension (4) contribue à la génération des demi-ondes de tension positive de la tension de test et une deuxième branche d'amplificateur de tension (5) contribue à la génération des demi-ondes de tension négative de la tension de test, et
- un circuit de mesure (17, 23, 24) pour mesurer la tension de test à appliquer à un objet de mesure et le courant de test provoqué par celle-ci dans l'objet de mesure,
**caractérisé en ce que** chaque branche d'amplificateur de tension (4, 5) est installée dans un module séparé (26, 26', 26", 27, 27', 27") avec un refroidissement d'air actif intégré (32, 33, 34, 35).

2. Appareil de test à haute tension selon la revendication 1, **caractérisé en ce que** la tension de test générée par la coopération des branches d'amplificateur de tension (4, 5) installées dans des modules séparés (26, 26', 26", 27, 27', 27") est une tension alternative à très basse fréquence (VLF) avec une fréquence comprise dans la plage entre 0,01 Hz et 1 Hz.

3. Appareil de test à haute tension selon une des revendications 1 ou 2, **caractérisé en ce que** les moyens de génération de la tension de test présentent un nombre pair n, avec n ≥ 4, sur les branches d'amplificateur de tension (4, 5), dans lequel chaque branche d'amplificateur de tension (4,5) est installée dans un module séparé (26, 26', 26", 27, 27', 27") avec un refroidissement d'air actif intégré (32, 33, 34, 35) et dans lequel l'appareil de test à haute tension (1) sous la synchronisation appropriée des branches d'amplificateur de tension (4, 5) est conçu afin que la première moitié (=n/2) des branches d'amplificateur de tension (4) pour la génération des demi-ondes de tension positive de la tension de test et la deuxième moitié (=n/2) des branches d'amplificateur de tension (5) pour la génération des demis ondes de tension négative de la tension de test coopèrent.

4. Appareil de test à haute tension selon une des revendications 1 à 3, **caractérisé en ce que** l'appareil de test à haute tension (1) est configuré et conçu de telle sorte que respectivement au moins une paire supplémentaire (4/5) sur les branches d'amplificateur de tension (4, 5) puisse être ajoutée aux moyens de génération de la tension de test jusqu'à un nombre maximal déterminé par le système sur des branches d'amplificateur de tension (4, 5), desquelles une première branche d'amplificateur de tension (4) contribue à la génération des demi-ondes de tension positive de la tension de test et une deuxième branche d'amplificateur de tension (5) contribue à la génération des demi-ondes de tension négative de la tension de test.

5. Appareil de test à haute tension selon une des revendications précédentes, **caractérisé en ce que** l'appareil de test à haute tension (4) présente une unité de commande centrale (3), qui est également installée dans un module séparé (2) et sur lequel un nombre pair d'éléments de connexion (30) pour la connexion d'au moins deux modules (26, 26', 26", 27, 27', 27") contenant respectivement une branche d'amplificateur de tension (4, 5) est prévu.

6. Appareil de test à haute tension selon la revendication 5, **caractérisé en ce que** sur le module (5) contenant l'unité de commande centrale un élément de connexion (6) pour la connexion et pour le contact électrique de l'objet de mesure est en outre prévu.

7. Appareil de test à haute tension selon la revendication 5 ou 6, **caractérisé en ce que** le module (2) contenant l'unité de commande centrale (3) comprend un boîtier pouvant être posé sur un sol et s'étendant en forme de tour dans la direction verticale, sur la circonférence latérale duquel, de préférence dans la zone d'extrémité supérieure duquel, au moins deux éléments de connexion (30) pour la connexion d'au moins deux modules (26, 26', 26", 27, 27', 27") contenant respectivement une branche d'amplificateur de tension (4, 5) sont prévus.

8. Appareil de test à haute tension selon la revendication 5 ou 6, **caractérisé en ce que** les modules (26, 26', 26", 27, 27', 27") contenant les branches d'amplificateur de tension individuelles (4, 5) présentent respectivement une première et une deuxième portion de boîtier (28, 29), dans lequel la première portion de boîtier (28) peut être posée sur un sol et s'étend en forme de tour dans la direction verticale et dans lequel la deuxième portion de boîtier (29), qui s'étend essentiellement dans la direction horizontale, et fixée avec une première extrémité à la première portion de boîtier (28), de préférence dans la zone extrémité supérieure de celle-ci et peut être raccordée avec une extrémité au module (2) contenant l'unité de commande centrale (3).

9. Appareil de test à haute tension selon la revendication 8, **caractérisé en ce que** dans la première et la deuxième portion de boîtier (28, 29) du module contenant une branche d'amplificateur de tension sont réalisés des canaux d'introduction d'air (35) relié les uns sous les autres, dans lequel dans la première portion de boîtier (28), de préférence à proximité du sol, une ouverture d'entrée (32) pour l'air de refroidissement est prévue et dans la deuxième portion de boîtier (29), de préférence dans la zone d'extrémité de celui-ci éloigné de la première portion de boîtier (28), une ouverture de sortie (33) pour l'air de refroidissement est prévue.

10. Appareil de test à haute tension selon la revendication 9, **caractérisé en ce que** l'air de refroidissement est aspiré au niveau de l'ouverture d'entrée (32) prévue dans la première portion de boîtiers (28) au moyen d'un ventilateur (34).

11. Appareil de test à haute tension selon la revendication 10, **caractérisé en ce que** au moins un ventilateur (34) ou une unité de commande commandant au moins un ventilateur (34) est configurée afin de, au besoin ou dans des intervalles temporels prescrits, provoquer une inversion du flux d'air à guider à travers le module à des fins de refroidissement.

12. Appareil de test à haute tension selon une des revendications précédentes, **caractérisé en ce que** le circuit de mesure (17, 23, 24) est disposé au moins partiellement dans le module (2) contenant l'unité de commande centrale (3).
